(19) **Europäisches Patentamt / European Patent Office / Office européen des brevets**

(11) **EP 4 287 449 B1**

(12) # EUROPEAN PATENT SPECIFICATION

(45) Date of publication and mention
of the grant of the patent:
**29.07.2026  Bulletin 2026/31**

(21) Application number: **22770254.5**

(22) Date of filing: **18.02.2022**

(51) International Patent Classification (IPC):
***H02J 7/00*** *(2026.01)*

(52) Cooperative Patent Classification (CPC):
**H02J 7/54; B60L 3/0046; B60L 3/0084; B60L 3/12;
B60L 58/22; H02J 7/80;** B60L 2240/545;
B60L 2240/547; B60L 2240/549; B60L 2240/80;
G01R 31/396; H02J 2105/37

(86) International application number:
**PCT/CN2022/076722**

(87) International publication number:
**WO 2022/193899 (22.09.2022 Gazette 2022/38)**

(54) **BALANCE MONITORING CONTROL SYSTEM AND METHOD FOR POWER BATTERY, SERVER, AND STORAGE MEDIUM**

BALANCEÜBERWACHUNGSSTEUERUNGSSYSTEM UND -VERFAHREN FÜR EINE LEISTUNGSBATTERIE, SERVER UND SPEICHERMEDIUM

SYSTÈME ET PROCÉDÉ DE COMMANDE DE SURVEILLANCE D'ÉQUILIBRAGE POUR BATTERIE D'ALIMENTATION, SERVEUR ET SUPPORT DE STOCKAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.03.2021  CN 202110291971**

(43) Date of publication of application:
**06.12.2023  Bulletin 2023/49**

(73) Proprietor: **China Faw Co., Ltd.**
**Changchun, Jilin 130011 (CN)**

(72) Inventors:
• **JIANG, Hui**
  **Changchun, Jilin 130011 (CN)**
• **LIU, Yixin**
  **Changchun, Jilin 130011 (CN)**
• **RONG, Changru**
  **Changchun, Jilin 130011 (CN)**
• **YANG, Yafei**
  **Changchun, Jilin 130011 (CN)**

• **TIAN, Chongwen**
  **Changchun, Jilin 130011 (CN)**
• **LIU, Pengfei**
  **Changchun, Jilin 130011 (CN)**
• **MENG, Shengkao**
  **Changchun, Jilin 130011 (CN)**
• **WANG, Yongchao**
  **Changchun, Jilin 130011 (CN)**

(74) Representative: **Novagraaf Group**
**Chemin de l'Echo 3**
**1213 Onex / Geneva (CH)**

(56) References cited:
CN-A- 103 119 827    CN-A- 106 042 961
CN-A- 106 042 961    CN-A- 108 233 469
CN-A- 109 742 818    CN-A- 109 742 818
CN-A- 111 490 304    CN-A- 113 054 706
CN-U- 201 947 015    JP-A- 2009 071 936
US-A1- 2011 127 960

# EP 4 287 449 B1

## Description

### Technical Field

The invention relates to the technical field of electric vehicles, in particular to a balance monitoring control system and method for power battery, server, and storage medium.

### Background

The automobile industry is undergoing faster development along with advances in technology. With a growing and irreversible trend in automobile electrification, an electric vehicle will be increasingly popular. Its battery pack is composed of several single cells in series, and the single cells are likely to be inconsistent in performance due to factors of production, aging, etc.

A single cell with worse performance in the battery module is a decisive factor for the use performance of the battery pack, stops the other single cells in the battery pack from presenting their best performance, and affects the capacity utilization rate of the battery pack accordingly. The balance control technology of a battery management system can effectively solve the performance inconsistency of several single cells in the battery pack despite an unsatisfactory or excessive equalization result. A balancing hardware circuit for balancing a power battery is unsatisfactory in balancing effect. Document CN 106 042 961 A is an example of prior art.

### Summary

The present invention provides a balance monitoring control system and method for power battery, a server, and a storage medium, which can effectively solve the problem of poor battery capacity consistency caused by unbalanced circuits in the power battery and the problem of a balancing function failure caused by a balance loop fault, a sampling problem, a software problem, etc. in a controller in the power battery.

In a first aspect, an example of the present invention provides a system for monitoring and controlling a balance of a power battery. The system includes: an input module, a balance monitoring control module and an execution module, the balance monitoring control module is connected witj the input module and the execution module separately;

the input module is configured to input a voltage of a sampling point of a balance loop, a temperature of a battery module, a current of the power battery and a voltage of a single cell into the balance monitoring control module;

the balance monitoring control module includes a battery pack balance pre-determination unit, a cell capacity difference balance control unit, a single cell voltage difference redundancy control unit, a balance loop diagnosing and monitoring unit and a balance watchdog monitoring unit;

the battery pack balance pre-determination unit is configured to pre-determine whether a battery pack is balanced based on the voltage of the single cell and a voltage of the battery module, where the voltage of the battery module is obtained based on the voltage of the single cell;

the single cell capacity difference balance control unit is configured to obtain a capacity of the single cell and a minimum capacity of the single cell based on the temperature of the battery module, the current of the power battery and the voltage of the single cell, determine whether a balance switch corresponding to the single cell is turned on based on a difference between the capacity of the single cell and the minimum capacity of the single cell, generate a first balance control instruction under the condition that the balance switch corresponding to the single cell is turned on, and send the first balance control instruction to the execution module;

the single cell voltage difference redundancy control unit is configured to monitor the voltage of the single cell in real time after the balance switch is turned on to obtain a monitoring result, determine whether to turn off the balance switch based on the monitoring result, generate a second balance control instruction in response to the balance switch being turned off, and send the second balance control instruction to the execution module;

the balance loop diagnosing and monitoring unit is configured to determine whether to turn off the balance switch based on the voltage of the sampling point of the balance loop after the balance switch is turned on, generate a third balance control instruction in response to the balance switch being turned off, and send the third balance control instruction to the execution module;

the balance watchdog monitoring unit is configured to monitor a program running of the system, determine whether to turn off the balance switch based on a monitoring result, generate a fourth balance control instruction in response to the balance switch being turned off, and send the fourth balance control instruction to the execution module;

the execution module is configured to control the balance switch based on the first balance control instruction or the second balance control instruction or the third balance control instruction or the fourth balance control instruction.

In a second aspect, the example of the present invention further provides a method for balance monitoring control a power battery. The method is executed by a monitoring mechanism of a three-layer software architecture in a balance monitoring control module, and includes:

obtaining a voltage of a single cell, a temperature of a battery module, a current of the power battery and a voltage of a sampling point of a balance loop;

pre-determining whether a battery pack is balanced according to the voltage of the single cell and a voltage of the battery module, where the voltage of the battery module is obtained according to the voltage of the single cell;

obtaining a capacity of the single cell and a minimum capacity of the single cell according to the temperature of the battery module, the current of the power battery and the voltage of the single cell, determining whether a balance switch corresponding to the single cell is turned on according to a difference between the capacity of the single cell and the minimum capacity of the single cell, generating a first balance control instruction under the condition that the balance switch corresponding to the single cell is turned on, and sending the first balance control instruction to an execution module;

monitoring the voltage of the single cell in real time after the balance switch is turned on, determining whether to turn off the balance switch according to a monitoring result, generating a second balance control instruction under the condition that the balance switch is turned off, and sending the second balance control instruction to the execution module;

determining whether to turn off the balance switch based on the voltage of the sampling point of the balance loop after the balance switch is turned on, generating a third balance control instruction in response to the balance switch being turned off, and sending the third balance control instruction to the execution module;

monitoring program running of a system, determining whether to turn off the balance switch based on a monitoring result, generating a fourth balance control instruction in response to the balance switch being turned off, and sending the fourth balance control instruction to the execution module.

In a third aspect, the present invention further provides a server. The server includes:

at least one processor;

a storage apparatus configured to store at least one program, wherein

the at least one program cause at least one processor to execute the method for monitoring and controlling a balance of a power battery based on any embodiment of the present invention in response to executing by the at least one processor.

In a fourth aspect, the embodiment of the present invention further provides a computer-readable storage medium storing a computer program, wherein the computer program implements the method for balance monitoring control for a power battery based on any embodiment of the present invention when executed by at least one processor.

## Brief Description of the Drawings

Fig. 1 is a schematic structural diagram of a system for balance monitoring control for a power battery according to an embodiment of the present invention;

Fig. 2 is a schematic structural diagram of a system for balance monitoring control for a power battery according to an embodiment of the present invention;

Fig. 3 is a schematic flowchart of a method for balance monitoring control for a power battery according to an embodiment of the present invention;

Fig. 4 is a schematic diagram of a software layer of a method for balance monitoring control for a power battery according to an embodiment of the present invention;

Fig. 5 is a flowchart of battery pack balance pre-determination according to an embodiment of the present invention;

Fig. 6 is a flowchart of single cell capacity difference balance control according to an embodiment of the present invention;

Fig. 7 is a flowchart of single cell balance control according to an embodiment of the present invention; and

Fig. 8 is a schematic structural diagram of a server according to an embodiment of the present invention.

## Detailed Description

Embodiments of the present invention will be described below with reference to accompanying drawings. Although some examples of the present invention are shown in the accompanying drawings, the present invention can be implemented in various forms and should not be constructed to be limited by the examples set forth herein. The accompanying drawings and the examples of the present invention are for illustration rather than limitation to the protection scope of the present invention.

Multiple steps described in a method embodiment of the present invention can be performed in a different order and/or in parallel. Further, the method embodiment can include an additional step and/or omit an illustrated step, which does not limit the scope of the present invention.

As used herein, the term "comprise" or "include" and its variants mean open-ended inclusion, that is, "including but not limited to". The term "based on" means "at least partially based on". The term "an example" means "at least one example". The term "another example" means "at least one another example". The term "some examples" means "at least some examples". Related definitions of other terms will be given in the following description.

Concepts such as "first" and "second" mentioned in the present invention are used to distinguish different devices, modules or units, rather than limit an order or interdependence of functions performed by these devices, modules or units.

Modifiers such as "a" and "plurality" mentioned in the present invention are schematic rather than limiting, and should be understood as "at least one" unless otherwise indicated in the context.

Names of messages or information exchanged between multiple apparatuses in an embodiment of the present invention are used for illustration rather than limitation to the scope of these messages or information.

A battery pack of an electric vehicle is composed of multiple single cells in series, and the single cells are likely to be inconsistent in performance due to factors of production, aging, etc. A single cell with worse performance in the battery module, a decisive factor for the use performance of the battery pack, stops the other single cells in the battery pack from presenting their best performance, and affects a capacity utilization rate of the battery pack accordingly. According to the present invention, by effectively controlling a software layer of a main controller in a battery management system in the battery pack, a single cell in a power battery is protected from the problems that a balance loop is out of control, some single cells fail to respond to an instruction, and worse consistence of single cells is caused by inconsistence in capacity of some single cells after excessive discharge or non-discharge due to the balance loop, software or hardware problems to avoid the problem that inconsistent single cells in the power battery may not be effectively improved due to the fact that a balance switch is turned on by mistake.

Embodiment One

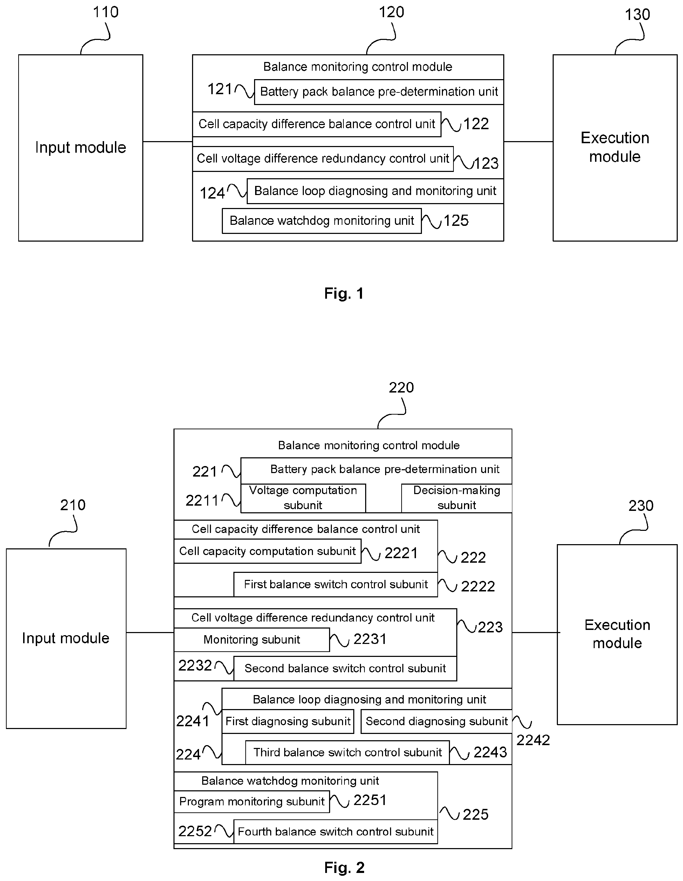

Fig. 1 is a schematic structural diagram of a system for balance monitoring control for a power battery according to embodiment one of the present invention. The system for balance monitoring control for a power battery may be used for balance monitoring and controlling in the power battery in the cases of unbalanced circuits in the power battery and a balance loop fault caused by a balance loop fault, a sampling problem, a software problem, etc. in a controller in the power battery. The system for balance monitoring control for a power battery may be implemented through software and hardware, and the balance monitoring control system of the power battery may include a balance monitoring and controlling module to determine whether it is necessary to generate a balance control instruction.

As shown in Fig. 1, the system for balance monitoring control for a power battery according to Embodiment 1 of the present invention includes:

An input module 110, a balance monitoring control module 120 and an execution module 130, where the balance monitoring control module 120 is connected with the input module 110 and the execution module 130 separately.

The input module 110 is configured to send a voltage of a sampling point of a balance loop, a temperature of a battery module, a current of the power battery and a voltage of a single cell into the balance monitoring and controlling module 120.

The balance monitoring and controlling module 120 includes a battery pack balance pre-determination unit 121, a single cell capacity difference balance control unit 122, a single cell voltage difference redundancy control unit 123, a balance loop diagnosing and monitoring unit 124 and a balance watchdog monitoring unit 125.

The battery pack balance pre-determination unit 121 is configured to pre-determine whether a battery pack is balanced according to the voltage of the single cell and a voltage of the battery module, where the voltage of the battery module is obtained according to the voltage of the single cell.

The single cell capacity difference balance control unit 122 is configured to obtain a capacity of the single cell and a minimum capacity of the single cell according to the temperature of the battery module, the current of the power battery and the voltage of the single cell, determine whether a balance switch corresponding to the single cell is turned on according to a difference between the capacity of the single cell and the minimum capacity of the single cell, generate a first balance control instruction under the condition that the balance switch corresponding to the single cell is turned on, and send the first balance control instruction to the execution module 130.

The single cell voltage difference redundancy control unit 123 is configured to monitor the voltage of the single cell in real time after the balance switch is turned on, determine whether to turn off the balance switch according to a monitoring result, generate a second balance control instruction under the condition that the balance switch is turned off, and send the second balance control instruction to the execution module 130.

The balance loop diagnosing and monitoring unit 124 is configured to determine whether to turn off the balance switch according to the voltage of the sampling point of the balance loop after the balance switch is turned on, generate a third balance control instruction under the condition that the balance switch is turned off, and send the third balance control instruction to the execution module 130.

The balance watchdog monitoring unit 125 is configured to monitor program running of a system, determine whether to turn off the balance switch according to a monitoring result, generate a fourth balance control instruction under the condition that the balance switch is turned off, and send the fourth balance control instruction to the execution module 130.

The execution module 130 is configured to control the balance switch according to the first balance control instruction, the second balance control instruction, the third balance control instruction or the fourth balance control instruction.

In this example, the input module 110 may be a module for inputting data, and the input module 110 may be connected to the balance monitoring and controlling module 120, and the system may transmit data required into the balance monitoring and controlling module 120 through the input module 110. The data required may include the voltage of the sampling point of the balance loop, the temperature of the battery module, the current of the power battery and the voltage of the single cell.

The voltage of the sampling point of the balance loop may be obtained after data processing is performed on voltages collect by multiple sampling points in the balance loop of the battery management system of the power battery. The temperature of the battery module may be obtained after filtering is performed on by a temperature data signal of the module converted from an analog digital (AD) signal in the power battery collected by a temperature sensor. The current of the power battery may be obtained after filtering and smoothing are performed on a current value converted from an AD signal collected by a current sensor. The single cell voltage may be a voltage of all single cells included in the power battery, and the voltage of the single cell may be obtained by sampling a chip.

In this embodiment, the balance monitoring and controlling module 120 may be a module that monitors the balance loop in the power battery, execution of the balance control instruction and program running, etc. The balance monitoring control module 120 may obtain data required by being connected to the input module 110, and the balance monitoring control module 120 may send a corresponding balance control instruction to the execution module 130 by being connected to the execution module 130, such that the execution module 130 may perform a corresponding operation to control the balance switch according to the balance control instruction.

The balance monitoring control module 120 is configured to send different balance control commands to the execution module 130 correspondingly according to a monitored situation in the case that capacities of multiple single cells in the power battery may not keep balanced as monitored.

The balance monitoring control module 120 may include a battery pack balance pre-determination unit 121, the battery pack balance pre-determination unit 121 may be a pre-determination unit, and the battery pack balance pre-determination unit 121 may be configured to determine and remove a battery module and a single cell that have poor consistency and may not be maintained through balancing according to a voltage threshold of the battery module and a voltage threshold of the single cell.

The power battery may include multiple battery modules, and each battery module may include multiple single cells.

A process that the battery pack balance pre-determination unit 121 is configured to pre-determine whether a battery pack is balanced according to the voltage of the single cell and a voltage of the battery module may be as follows: a voltage of each battery module may be computed according to single cell voltages of multiple single cells included in each battery module, that is, the voltage of the battery module may be obtained by totaling the single cell voltages. According to the voltage of each battery module, an average voltage of the battery modules may be computed, and an average voltage of the single cells may be computed according to single cell voltages of all single cells. Whether a difference between the voltage of each module and the average voltage of the battery module is greater than a first set threshold is sequentially determined, and a battery module having a corresponding difference greater than the first set threshold is removed from the battery pack and maintained off line. Whether a difference between the voltage of each single cell and the average voltage of the single cell is greater than a second set threshold is sequentially determined, and a single cell having a corresponding difference greater than the second set threshold is removed from the battery pack and maintained off line. A battery pack obtained through the above process is a battery pack that may be maintained through balancing.

The balance monitoring control module 120 may include a single cell capacity difference balance control unit 122, and the single cell capacity difference balance control unit 122 may be configured to control the balance switch to be turned on or turned off through a single cell capacity difference method.

A process that the balance monitoring control module 120 is configured to control the balance switch to be turned on or turned off may be as follows: according to the temperature of the module and the current of the power battery, stabilization duration when the voltage of the single cell keeps a stable voltage may be found through a two-dimensional timetable. Duration when the current of the power battery is lower than a preset current is computed. States of charge (SOC) of different single cells may be obtained according to single cell voltages of different single cells and an open-circuit voltage method if the duration or a vehicle sleep time is longer than the stabilization duration. Capacities of different single cells may be computed based on the SOC, and a minimum capacity of the single cell may be determined. A difference between the capacity of each single cell and the minimum capacity of the single cell is sequentially obtained, and a first balance control instruction is generated after a balance switch of a single cell having a difference greater than a set threshold is turned on.

The time two-dimensional table may be obtained through experiments in advance, and may record stabilization duration when the single cell keeps the stable voltage at different temperatures and different currents of the power battery. According to an input temperature of the module and an input current of the power battery, corresponding stabilization duration of the single cell may be found correspondingly. Since all single cells in the battery pack have the same model, that is, corresponding stabilization duration of the single cells under the same temperature of the module and the same current of the power battery are the same.

The sleep time may be obtained through a chip of the main controller of the battery management system (BMS), and the vehicle sleep time may be input to the balance monitoring control module 120 through the input module 110.

The balance monitoring control module 120 may further include the single cell voltage difference redundancy control unit 123, the single cell voltage difference redundancy control unit 123 may be configured to monitor the voltage of the single cell in real time and determine whether to turn off the balance switch of the single cell according to a maximum voltage and a minimum voltage of the single cell.

A process that the single cell voltage difference redundancy control unit 123 is configured to determine whether to turn off the balance switch according to a monitoring result is as follows: the voltage of the single cell is monitored in real time, and a maximum voltage of the single cell and a minimum voltage of the single cell among all single cells are determined at each moment, a difference between the maximum voltage of the single cell and the minimum voltage of the single cell is obtained, and if an absolute value of the difference is within a set threshold range, the balance switch of the single cell is determined to be turned off.

The balance monitoring control module 120 may further include the balance loop diagnosing and monitoring unit 124, and the balance loop diagnosing and monitoring unit 124 may monitor balance reliability of the balance loop to guarantee that the balance switch may be turned on or off.

The balance loop diagnosing and monitoring unit 124 is configured to diagnose whether an open-circuit fault or a short-circuit fault of the balance loop occurs, turn off all balance switches when it is determined that the open-circuit fault occurs, and maintain the balance loop when it is determined that the short-circuit fault or the open-circuit fault occurs.

The balance monitoring control module 120 may further include the balance watchdog monitoring unit 125, and the balance watchdog monitoring unit 125 may monitor control program running of a system to prevent a balance switch turning-on fault due to a controller problems or program runaway problem.

The balance watchdog monitoring unit 125 may be configured with sampling chip hardware for activating a balance watchdog monitoring function.

Illustratively, the balance watchdog monitoring unit 125 is configured to monitor program running and data transmission of the system, and if data transmission and program running are monitored to be normal, kicking the dog is continuously performed, that is, a single cell balance watchdog is continuously added by 1. In response to the single cell balance watchdog being monitored to be unequal to 0, a balancing state is maintained. In response to data transmission being monitored to terminate and duration after the balance switch is turned on is monitored to reach a set threshold, the single cell balance watchdog is set to 0.

In this example, the execution module 130 controls the balance switch to be turned on or turned off according to the instruction, and the execution module 130 obtains the first balance control instruction, the second balance control instruction, the third balance control instruction and the fourth balance control instruction sent by the balance monitoring control module 120 by being connected to the balance monitoring control module 120. The execution module 130 controls the balance switch according to different instructions received.

According to the system for monitoring and controlling a balance of a power battery of embodiment 1 of the present invention, the input module sends the voltage of the sampling point of the balance loop, the temperature of the battery module, the current of the power battery and the voltage of the single cell into the balance monitoring control module, the battery pack balance pre-determination unit of the balance monitoring and controlling unit pre-determines whether the battery pack is balanced according to the voltage of the single cell and the voltage of the battery module, and the single cell capacity difference balance control unit obtains the capacity of the single cell and the minimum capacity of the single cell according to the temperature of the battery module, the current of the power battery and the voltage of the single cell, determines whether the balance switch corresponding to the single cell is turned on according to the difference between the capacity of the single cell and the minimum capacity of the single cell, generates the first balance control instruction under the condition that the balance switch corresponding to the single cell is turned on, and sends the first balance control instruction to the execution module. The single cell voltage difference redundancy control unit of the balance monitoring control module monitors the voltage of the single cell in real time after the balance switch is turned on, determines whether to turn off the balance switch according to the monitoring result, generates the second balance control instruction under the condition that the balance switch is turned off, and sends the second balance control instruction to the execution module. The balance loop diagnosing and monitoring unit of the balance monitoring control module determines whether to turn off the balance switch according to the voltage of the sampling point of the balance loop after the balance switch is turned on, generates the third balance control instruction under the condition that the balance switch is turned off, and sends the third balance control instruction to the execution module. The balance watchdog monitoring unit of the balance monitoring control module monitors program running of a system, determines whether to turn off the balance switch according to the monitoring result, generates the fourth balance control instruction under the condition that the balance switch is turned off, and sends the fourth balance control instruction to the execution module. The execution module controls the balance switch according to the first balance control instruction, the second balance control instruction, the third balance control instruction or the fourth balance control instruction. With a technical solution above, the problem of poor battery capacity consistency caused by unbalanced circuits in the power battery and the problem of a balancing function fault caused by a balance loop fault, a sampling problem, a software problem, etc. in the controller in the power battery may be effectively solved.

Embodiment Two

Fig. 2 is a schematic structural diagram of a system for balance monitoring control for a power battery according to embodiment two of the present invention. Embodiment two is described based on embodiment one. Reference may be made to embodiment one for contents not detailed, and such contents will not be repeated herein.

In this example, a battery pack balance pre-determination unit 221 may include a voltage computation subunit 2211 and a decision-making subunit 2212.

The voltage computation subunit 2211 may be configured to compute an average voltage of a single cell and a voltage of a battery module based on a voltage of the single cell and according to a formula as follows:

$$Usavg = \sum_{0}^{m} Uis/m, Uimod = \sum_{0}^{n} Uis$$

wherein Uis represents the voltage of the single cell, m represents the number of single cells in the power battery, n represents the number of single cells in the battery module, *Usavg* represents the average voltage of the single cell, and *Uimod* represents the voltage of the battery module, and an average voltage of the battery module is computed based on the voltage of the battery module and according to a formula as follows:

$$Umavg = Uimod/Nmod$$

wherein *Umavg* represents the average voltage of the battery module, and *Nmod* represents the number of modules in the battery pack.

The decision-making subunit 2212 is configured to sequentially determine whether a difference between a voltage of each battery module and the average voltage of the battery module and a first preset threshold satisfy a formula:| *Uiomd - Umavg*| > *ΔUm,* wherein *ΔUm* represents the first preset threshold, and the decision-making subunit determines the battery module as an abnormal battery module under the condition that the formula is satisfied.

The decision-making subunit 2212 is further configured to sequentially determine whether a difference between a voltage of each single cell and the average voltage of the single cell and a second preset threshold satisfy a formula as follows:

$$|Uis - Usavg| > \Delta Us$$

the decision-making subunit determines the single cell as an abnormal single cell under the condition that the formula is satisfied; where *ΔUs* represents the second preset threshold.

In this example, the single cell capacity difference balance control unit 222 may include a single cell capacity computation subunit 2221 and a first balance switch control subunit 2222.

The single cell capacity computation subunit 2221 is configured to obtain stabilization duration when the voltage of the single cell keeps a stable voltage through interpolation in a two-dimensional timetable according to a temperature of the battery module and a current of the power battery, and the two-dimensional timetable is a two-dimensional table of a temperature, a current of the power battery and stabilization duration obtained according to a battery pack bench test. The interpolation may be understood as linear interpolation.

The single cell capacity computation subunit 2221 is configured to compute current duration when the current of the power battery is lower than a preset current.

The single cell capacity computation subunit 2221 is further configured to obtain a state of charge (SOC) of the single cell through an open-circuit voltage method after determining that the current duration or a vehicle sleep time is longer than the stabilization duration, and compute a capacity of the single cell based on the SOC of the single cell and according to a formula as follows:

$$Ahis = SOC * C$$

wherein C represents a nominal capacity, and *Ahis* represents the capacity of the single cell.

The single cell capacity computation subunit is further configured to determine the minimum capacity of the single cell according to a formula:*Ahsmin = min*(*Ahis*), wherein *Ahsmin* represents the minimum capacity of the single cell.

The first balance switch control subunit 2222 is configured to sequentially obtain a difference between a capacity of each single cell and the minimum capacity of the single cell, and turn on a balance switch of a single cell satisfying a formula as follows:

$$Ahis - Ahsmin > \Delta Ahs$$

wherein *ΔAhs* represents a set threshold of a difference in the capacity of the single cell.

In this example, the single cell voltage difference redundancy control unit 223 may include: a monitoring subunit 2231 and a second balance switch control subunit 2232.

The monitoring subunit 2231 is configured to monitor the voltage of the single cell in real time, compute a maximum voltage of the single cell, and compute a minimum voltage of the single cell after the balance switch is turned on.

The second balance switch control subunit 2232 is configured to sequentially determine to turn off balance switches of all single cells under the condition that a difference between the maximum voltage of the single cell and the minimum voltage of the single cell and the set threshold satisfy a formula: |*Uismax - Uismin*| ≤ *ΔU,* wherein *Uismax* represents the maximum voltage of the single cell, *Uismin* represents the minimum voltage of the single cell, and *ΔU* represents the set threshold.

In this example, the balance loop diagnosing and monitoring unit 224 may include a first diagnosing subunit 2241, a second diagnosing subunit 2242 and a third balance switch control subunit 2243.

The first diagnosing subunit 2241 is configured to diagnose whether an open-circuit fault of the balance loop occurs after the balance switch is turned on.

The second diagnosing subunit 2242 is configured to diagnose whether a short-circuit fault of the balance loop occurs after the balance switch is turned off.

The third balance switch control subunit 2243 is configured to turn off all balance switches under the condition that it is determined that the open-circuit fault occurs, and maintain the balance loop under the condition that it is determined that a short-circuit fault or the open-circuit fault occurs.

Illustratively, the step that the first diagnosing subunit 2241 is configured to diagnose whether an open-circuit fault of the balance loop occurs includes: a voltage of a sampling point of the balance loop is periodically read, and the voltage is compared with an open-circuit voltage of a balance switch, an open-circuit threshold of the balance switch, an open-circuit voltage of a balance short-circuit switch and a short-circuit or open-circuit threshold of the balance loop in a balance register of a sampling chip. Two situations may be included as follows:

When the balance switch is turned on, the open-circuit fault of the balance loop is diagnosed, voltages of multiple sampling point of the balance loop may be periodically read, and the voltage is separately compared with the open-circuit voltage of the balance switch and an open-circuit threshold of the balance loop, and if the voltage is greater than the open-circuit voltage of the balance switch and/or the voltage is greater than the open-circuit threshold of the balance loop, it is determined that the open-circuit fault of the balance loop occurs.

When the balance switch is turned off, the short-circuit fault of the balance loop is diagnosed, a voltage of a sampling point of the balance loop may be periodically read, and the voltage is separately compared with the open-circuit voltage of the balance short-circuit switch and the short-circuit or open-circuit threshold of the balance loop, and if the voltage is greater than the open-circuit voltage of the balance short-circuit switch and/or the short-circuit or open-circuit threshold of the balance loop, it is determined that the short-circuit fault of the balance loop occurs.

In this example, the balance watchdog monitoring unit 225 includes a program monitoring subunit 2251 and a fourth balance switch control subunit 2252.

The program monitoring subunit 2251 is configured to monitor system program running and data transmission of the balance monitoring control module in real time.

The fourth balance switch control subunit 2252 is configured to continuously add a watchdog by 1 under the condition that program running is monitored to be normal, and turn off all balance switches under the condition that program running is monitored to be abnormal and duration after the balance switches are turned on is monitored to reach preset time.

The execution module 230 is configured to send a first balance control instruction, a second balance control instruction, a third balance control instruction or a fourth balance control instruction to a balance switch register, and cause the balance switch register to turn on or off the balance switch according to the first balance control instruction, the second balance control instruction, the third balance control instruction or the fourth balance control instruction.

According to the system for balance monitoring control for a power battery of embodiment 2 of the present invention, the problems that the balance loop is out of control, some single cells fail to respond to an instruction, and worse consistence of single cells is caused by inconsistence in capacity of some single cells after excessive discharge or non-discharge due to the balance loop, software or hardware problems may be effectively solved.

Embodiment Three

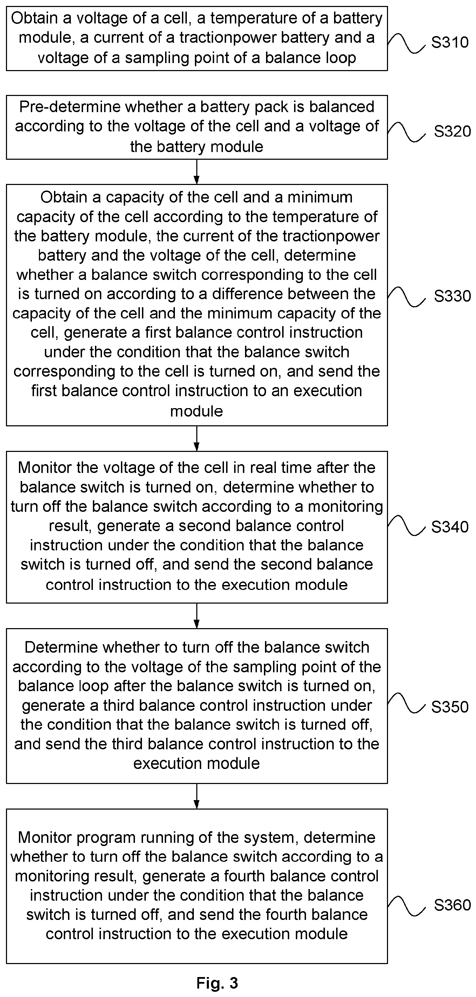

Fig. 3 is a schematic flowchart of a method for monitoring and controlling a balance of a power battery according to embodiment three of the present invention. This embodiment may used for balance monitoring control in the power battery in the case of unbalanced circuits in the power battery. The method may be executed by a monitoring mechanism of a three-layer software architecture in a balance monitoring control module of the system for monitoring and controlling a balance of a power battery according to the example above, and the system may be implemented through software and hardware. The method includes:
S310: a voltage of a single cell, a temperature of a battery module, a current of the power battery and a voltage of a sampling point of a balance loop are obtained.

The voltage of the single cell, the temperature of the battery module, the current of the power battery and the voltage of the sampling point of the balance loop may be collected and input to the system for monitoring and controlling a balance of a power battery through an input module.

S320: whether a battery pack is balanced is pre-determined according to the voltage of the single cell and a voltage of the battery module.

The voltage of the battery module is obtained according to the voltage of the single cell.

In this step, a voltage computation subunit computes an average voltage of the single cell and the voltage of the battery module based on the voltage of the single cell and according to a formula as follows:

$$Usavg = \sum_{0}^{m} Uis/m \, , Uimod = \sum_{0}^{n} Uis$$

where *Uis* represents the voltage of the single cell, m represents the number of single cells in the power battery, n represents the number of single cells in the battery module, *Usavg* represents the average voltage of the single cell, and *Uimod* represents the voltage of the battery module, and an average voltage of the battery module is computed based on the voltage of the battery module and according to a formula as follows:

$$Umavg = Uimod/Nmod$$

**where** *Umavg* represents the average voltage of the battery module, and *Nmod* represents the number of modules in the battery pack.

A decision-making subunit sequentially determines whether a difference between a voltage of each battery module and the average voltage of the battery module and a first preset threshold satisfy a formula: |*Uiomd - Umaug*| > *ΔUm,* where *ΔUm* represents the first preset threshold, and the decision-making subunit determines the battery module as an abnormal battery module under the condition that the formula is satisfied. The decision-making subunit sequentially determines whether a difference between a voltage of each single cell and the average voltage of the single cell and a second preset threshold satisfy a formula as follows:

$$|Uis - Usavg| > \Delta Us$$

The decision-making subunit determines the single cell as an abnormal single cell under the condition that the formula is satisfied; where *ΔUs* represents the second preset threshold.

S330: a single cell capacity and a minimum single cell capacity are obtained according to the temperature of the battery module, the current of the power battery and the voltage of the single cell, whether a balance switch corresponding to the single cell is turned on is determined according to a difference between the capacity of the single cell and the minimum capacity of the single cell, a first balance control instruction is generated under the condition that the balance switch corresponding to the single cell is turned on, and the first balance control instruction is sent to an execution module.

In this step, a single cell capacity computation subunit may obtain stabilization duration when the voltage of the single cell keeps a stable voltage through interpolation in a two-dimensional timetable according to the temperature of the battery module and the current of the power battery. The single cell capacity computation subunit computes current duration when the current of the power battery is lower than a preset current. The single cell capacity computation subunit obtains a SOC of the single cell through an open-circuit voltage method after determining that the current duration or a vehicle sleep time is longer than the stabilization duration, and computes the capacity of the single cell based on the SOC of the single cell and according to a formula as follows:

$$Ahis = SOC * C$$

where C represents a nominal capacity, and *Ahis* represents the capacity of the single cell.

The single cell capacity computation subunit is further configured to determine the minimum capacity of the single cell according to a formula: *Ahsmin = min*(*Ahis*), where *Ahsmin* represents the minimum capacity of the single cell.

A first balance switch control subunit sequentially obtains a difference between a capacity of each single cell and the minimum capacity of the single cell, and turns on a balance switch of a single cell satisfying a formula as follows:

$$Ahis - Ahsmin > \Delta Ahs$$

where *ΔAhs* represents a set threshold of a difference in the capacity of the single cell.

S340: the voltage of the single cell is monitored in real time after the balance switch is turned on, whether to turn off the balance switch is determined according to a monitoring result, a second balance control instruction is generated under the condition that the balance switch is turned off, and the second balance control instruction is sent to the execution module.

In this step, a monitoring subunit monitors the voltage of the single cell in real time, computes a maximum voltage of the single cell, and computes a minimum voltage of the single cell after the balance switch is turned on. A second balance switch control subunit determines to turn off balance switches of all single cells under the condition that a difference between the maximum voltage of the single cell and the minimum voltage of the single cell and the set threshold satisfy a formula: |*Uismax - Uismin*| ≤ *ΔU,* where *Uismax* represents the maximum voltage of the single cell, *Uismin* represents the minimum voltage of the single cell, and $\varDelta U$ represents the set threshold.

S350: whether to turn off the balance switch is determined according to the voltage of the sampling point of the balance loop after the balance switch is turned on, a third balance control instruction is generated under the condition that the balance switch is turned off, and the third balance control instruction is sent to the execution module.

In this step, a first diagnosing subunit may diagnoses whether an open-circuit fault of a balance loop occurs after the balance switch is turned on. A second diagnosing subunit diagnoses whether a short-circuit fault of the balance loop occurs. All balance switches are turned off under the condition that it is determined that the open-circuit fault occurs, and the balance loop is maintained under the condition that it is determined that a short-circuit fault or the open-circuit fault occurs.

S360: program running of a system is monitored, whether to turn off the balance switch is determined according to a monitoring result, a fourth balance control instruction is generated under the condition that the balance switch is turned off, and the fourth balance control instruction is sent to the execution module.

In this step, a program monitoring subunit monitors system program running and data transmission of the balance monitoring control module in real time. A fourth balance switch control subunit continuously adds a watchdog by 1 under the condition that program running is monitored to be normal by the fourth balance switch control subunit, and turns off all balance switches under the condition that program running is monitored to be abnormal and duration after the balance switches are turned on is monitored to reach preset time by the fourth balance switch control subunit.

According to the method for monitoring and controlling a balance of a power battery of embodiment three of the present invention, the method for balance monitoring control is described for the system for balance monitoring control for a power battery. With the method, the problem of poor battery capacity consistency caused by unbalanced circuits in the power battery may be effectively solved.

Embodiment Four

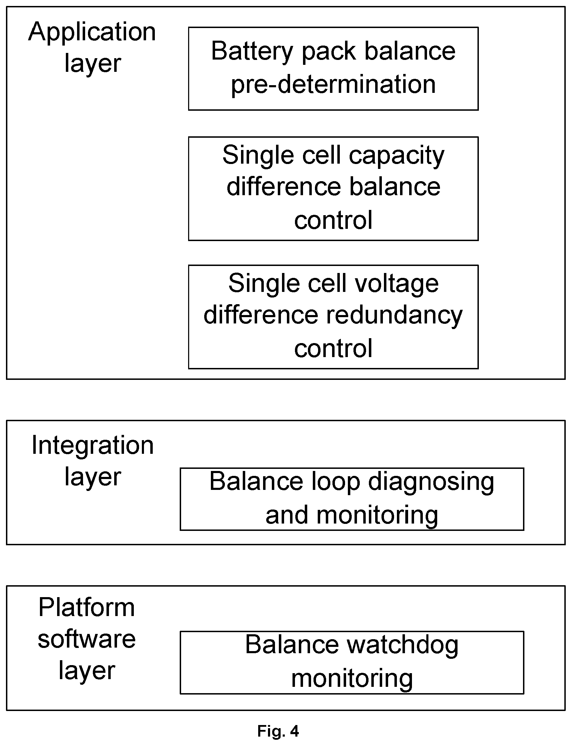

On the basis of the embodiments above, embodiment four of the present invention illustratively describes a method for monitoring and controlling a balance of a power battery. Fig. 4 is a schematic diagram of a software layer of the method for balance monitoring control for a power battery according to embodiment four of the present invention. As shown in Fig. 4, a three-layer software architecture in a balance monitoring control module includes an application layer, an integration layer and a platform software layer. The present invention layer may pre-determine whether a battery pack is balanced, and perform single cell capacity difference balance control and single cell voltage difference redundancy control. The integration layer may monitor and diagnose a balance loop. The platform software layer may perform balance watchdog monitoring.

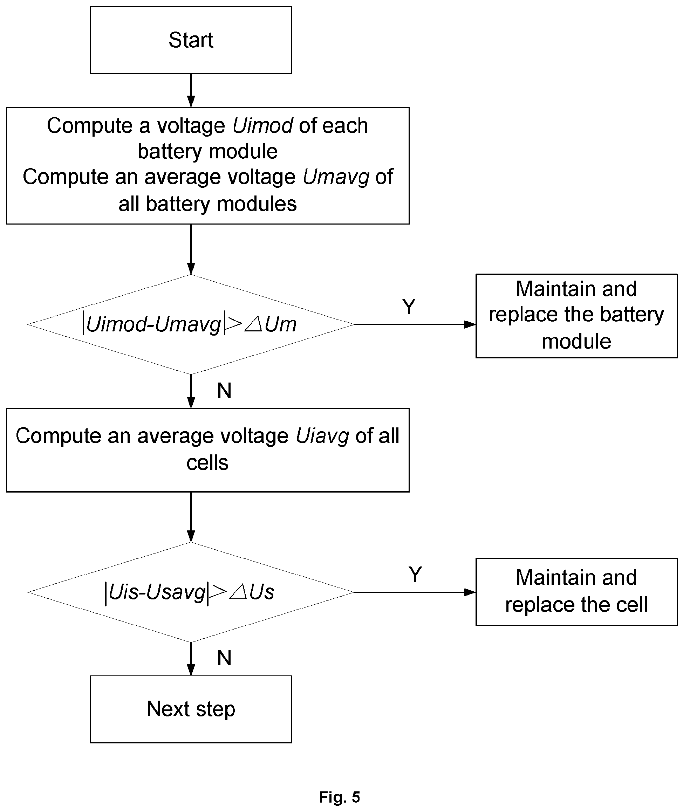

Illustratively, Fig. 5 is a flowchart of battery pack balance pre-determination according to embodiment four of the present invention, and a process of pack balance pre-determination according may be described. As shown in Fig. 5, pack balance pre-determination includes:

Step 1: a voltage $Uimod$ of each battery module is computed, and an average voltage $Umavg$ of all battery modules is computed.

Step 2: the voltage $Uimod$ of each battery module is compared with $Uwavg$ sequentially, and a battery module having a difference greater than a threshold $\varDelta Um$ is screened out and maintained and replaced.

Offline maintenance may be activated to maintain a screened abnormal battery module, such that a battery pack obtained after removing the abnormal battery module may be subjected to step 3.

Step 3: an average voltage $Uiavg$ of all single cells is computed.

Step 4: the voltage $Ui$ of the single cell collected is compared with $Uiavg$ sequentially, and a single cell having a difference greater than a threshold $\varDelta Us$ is screened out and maintained and replaced.

Offline maintenance may be activated to maintain a screened abnormal single cell, such that a battery pack obtained after removing the abnormal single cell may be subjected to single cell capacity difference balance control.

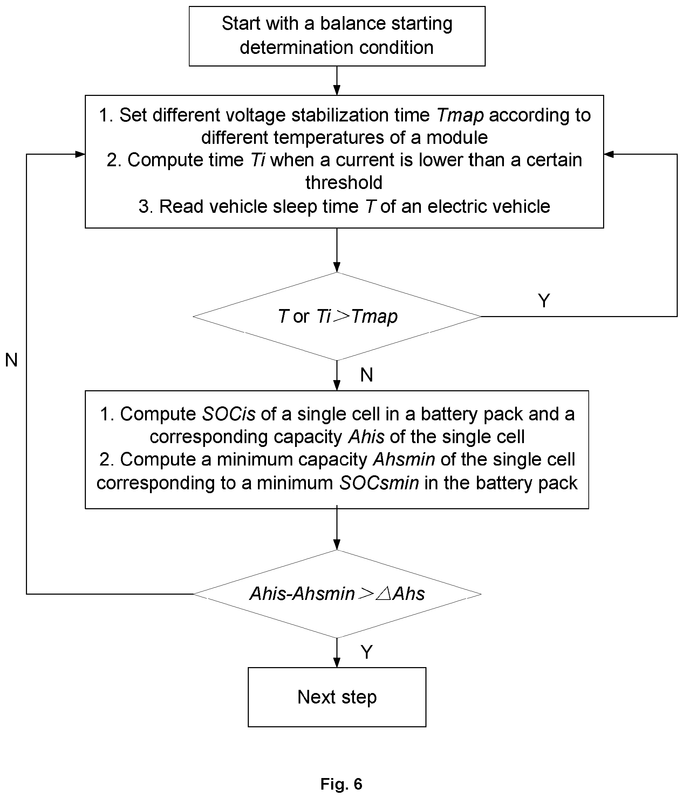

Illustratively, Fig. 6 is a flowchart of single cell capacity difference balance control according to embodiment four of the present invention. As shown in Fig. 6, the single cell capacity difference balance control may include:

Step 1, different voltage stabilization duration $Tmap$ is set according to different temperature samples of the battery module, stabilization duration $Ti$ when a current of the power battery is lower than a threshold is computed, and vehicle sleep time $T$ of an electric vehicle is read.

Step 2: whether $T$ or $Ti$ is greater than $Tmap$ is determined, and if so, step 1 is re-executed; otherwise, step 3 is executed.

Step 3: *SOCis* of the single cell in the battery pack and a corresponding capacity *Ahis* of the single cell are computed, and a minimum capacity *Ahsmin* corresponding to a minimum SOCis of the battery pack is determined.

Step 4: a difference between each *Ahis* and *Ahsmin* is obtained sequentially, and whether the difference is greater than a threshold *⊿Ahs* is determined, if so, a balance switch of the single cell is turned on; otherwise, step 1 is re-executed.

When the balance switch of the single cell is turned on, the single cell having the balance switch turned on may further be balanced.

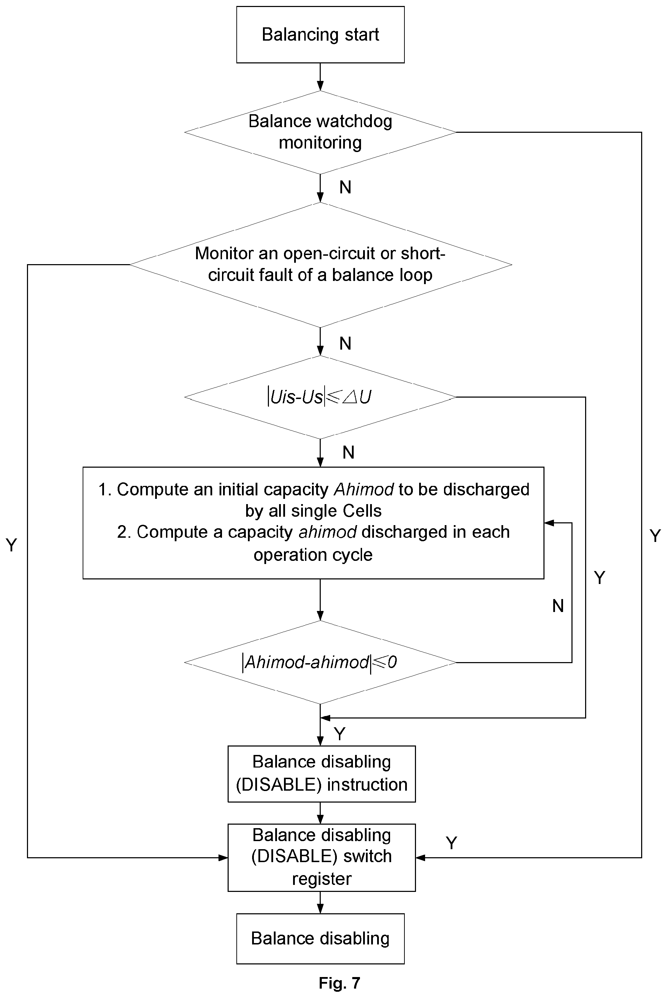

Illustratively, Fig. 7 is a flowchart of single cell balance control according to embodiment four of the present invention. The single cell balance control may include balance watchdog monitoring, balance loop diagnosing and monitoring, and single cell voltage difference redundancy control. As shown in Fig. 7, the single cell balance control may include:

Step 1: whether information monitored by a balance watchdog satisfies a condition is determined, and if so, step 7 is executed; otherwise, step 2 is executed.

Step 2: a fault of a balance loop is monitored, and if a fault is monitored, step 7 is executed; otherwise, step 3 is executed.

Step 3: whether a difference between a voltage *Uis* of the single cell and a minimum voltage Us of the single cell is less than a threshold *⊿U* is determined, if so, step 6 is executed; otherwise, step 4 is executed.

Step 4: an initial capacity *Ahimod* to be discharged by all single cells is computed, and a capacity *ahimod* discharged by the single cell in each operation cycle is computed and accumulated.

Step 5: whether an absolute value of a difference between *Ahimod* and *ahimod* is less than or equal to 0, if not so, step 4 is re-executed; otherwise, step 6 is continuously executed.

Step 6: a balance DISABLE instruction is sent.

Step 7: through a balance DISABLE switch register, a balance switch is turned off.

According to the method for balance monitoring control for a power battery of embodiment four of the present invention, the abnormal battery module and the abnormal single cell may be screened out through pre-determination before the balance switch of the battery pack is turned on to prevent the consistency problem of the single cell difficult to maintain through a balancing function of the power battery itself due to reasons such as a battery production batch, battery production process inconsistency and battery aging. As for the single cell capacity difference balance control, a capacity difference of multiple single cells may be used as a control condition of turning-on of the balance switch, and an excess capacity of the single cell is discharged by connecting the balance loop until the plurality of single cells satisfy a capacity consistency requirement. A battery pack balancing function uses a voltage difference of the single cell as redundant protection of the balance switch, and the voltage of the single cell is directly monitored and processed by a collection module, and the balance switch may be turned off as long as the voltage difference of the single cell satisfies a minimum set voltage difference threshold regardless of a load current to prevent excessive balancing caused by a computation error, etc. As for balance loop diagnosis and protection in the integration layer, the balance loop is monitored in real time after the balance switch is turned on to guarantee that the plurality of single cells are not turned on by mistake or even not turned on. As for the platform software layer balance watchdog monitoring, once the problems such as program runaway or a communication fault are monitored through configuration of the platform software layer, the balance loop is directly disconnected through the register.

Embodiment Five

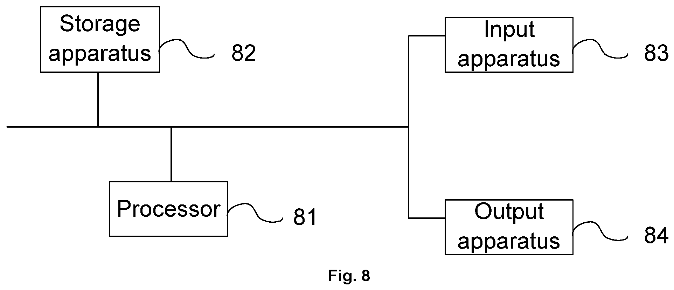

Fig. 8 is a schematic structural diagram of a server according to embodiment five of the present invention. As shown in Fig. 8, the server according to embodiment five of the present invention includes: at least one processors 81 and a storage apparatus 82. At least one processors 81 may be arranged in the server, and one processor 81 is taken as an example in Fig. 8. The storage apparatus 82 is configured to store at least one program, and the at least one programs cause at least one processors 81 to implement the method for monitoring and controlling a balance of a power battery according any example of the present invention when executed by the at least one processors 81.

The server may further include an input apparatus 83 and an output apparatus 84.

The processor 81, the storage apparatus 82, the input apparatus 83 and the output apparatus 84 in the server may be connected through a bus or other means, and connection through the bus is taken as an example Fig. 8.

As a computer-readable storage medium, the storage apparatus 82 in the server may be set to store at least one programs, the program may be a software program, a computer-executable program and a module, such as the program instruction/the module corresponding to the method for monitoring and controlling a balance of a power battery according to embodiment one or embodiment two of the present invention. The processor 81 executes various functional applications and data processing of the server by running the software program, the instruction and the modules stored in the storage apparatus 82, that is, the method for monitoring and controlling a balance of a power battery in the above method example is implemented.

The storage apparatus 82 may mainly include a program storage area and a data storage area, where the program storage area may be used to store an operating system, application programs required for at least one function. The data storage area may store data, etc. created according to use of the server. In addition, the storage apparatus 82 may include a high-speed random access memory, and may further include a non-volatile memory such as at least one disk storage device, a flash storage device or another non-volatile solid-state storage device. In some examples, the storage apparatus 82 may include a memory that is remotely arranged relative to the processor 81, and the remote memory may be connected to a device through a network. Instances of the network include but are not limited to the Internet, an Intranet, a local area network, a mobile communication network and their combinations.

The input apparatus 83 may be configured to receive input numeric or character information and generate key signal input related to user settings and function control of the server. The output apparatus 84 may include a display device such as a display screen.

When at least one programs included in the server are executed by at least one processors 81, the programs perform the following operations:

A voltage of a single cell, a temperature of a battery module, a current of a power battery and a voltage of a sampling point of a balance loop are obtained.

Whether a battery pack is balanced is pre-determined according to the voltage of the single cell and a voltage of the battery module, where the voltage of the battery module is obtained according to the voltage of the single cell.

A capacity of the single cell and a minimum capacity of the single cell are obtained according to the temperature of the battery module, the current of the power battery and the voltage of the single cell, whether a balance switch corresponding to the single cell is turned on is determined according to a difference between the capacity of the single cell and the minimum capacity of the single cell, a first balance control instruction is generated under the condition that the balance switch corresponding to the single cell is turned on, and the first balance control instruction is sent to an execution module.

The voltage of the single cell is monitored in real time after the balance switch is turned on, whether to turn off the balance switch is determined according to a monitoring result, a second balance control instruction is generated under the condition that the balance switch is turned off, and the second balance control instruction is sent to the execution module.

Whether to turn off the balance switch is determined according to the voltage of the sampling point of the balance loop after the balance switch is turned on, a third balance control instruction is generated under the condition that the balance switch is turned off, and the third balance control instruction is sent to the execution module.

Program running of a system is determined, whether to turn off the balance switch is determined according to a monitoring result, a fourth balance control instruction is generated under the condition that the balance switch is turned off, and the fourth balance control instruction is sent to the execution module.

Embodiment Six

Embodiment six of the present invention provides a computer-readable storage medium storing a computer program, wherein the computer program executes a method for monitoring and controlling a balance of a power battery when executed by a processor. The method includes:

A voltage of a single cell, a temperature of a battery module, a current of the power battery and a voltage of a sampling point of a balance loop are obtained.

Whether a battery pack is balanced is pre-determined according to the voltage of the single cell and a voltage of the battery module, where the voltage of the battery module is obtained according to the voltage of the single cell.

A capacity of the single cell and a minimum capacity of the single cell are obtained according to the temperature of the battery module, the current of the power battery and the voltage of the single cell, whether a balance switch corresponding to the single cell is turned on is determined according to a difference between the capacity of the single cell and the minimum capacity of the single cell, a first balance control instruction is generated under the condition that the balance switch corresponding to the single cell is turned on, and the first balance control instruction is sent to an execution module.

The voltage of the single cell is monitored in real time after the balance switch is turned on, whether to turn off the balance switch is determined according to a monitoring result, a second balance control instruction is generated under the condition that the balance switch is turned off, and the second balance control instruction is sent to the execution module.

Whether to turn off the balance switch is determined according to a voltage of a sampling point of a balance loop after the balance switch is turned on, a third balance control instruction is generated under the condition that the balance switch is turned off, and the third balance control instruction is sent to the execution module.

Program running of the system is determined, whether to turn off the balance switch is determined according to a monitoring result, a fourth balance control instruction is generated under the condition that the balance switch is turned off, and the fourth balance control instruction is sent to the execution module.

Alternatively, the program may execute the method for monitoring and controlling a balance of a power battery according to any embodiment of the present invention when executed by a processor.

The computer storage medium according to the example of the present invention may adopt any combination of at least one computer-readable media. The computer-readable medium may be a computer-readable signal medium or a computer-readable storage medium. The computer-readable storage medium may be, for example, an electric, magnetic, optical, electromagnetic, infrared, or semiconductor system, apparatus or device, or any combination of the above. A computer-readable storage medium includes an electrical connection with at least one wires, a portable computer disk, a hard disk, a random access memory (RAM), a read only memory (ROM), an erasable programmable read only memory (EPROM), a flash memory, an optical fiber, a compact disc read only memory (CD-ROM), an optical storage device, a magnetic storage device, or any suitable combination of the above. The computer-readable storage medium may be any tangible medium encompassing or storing a program, ant the program may be used by or in combination with an instruction execution system, apparatus or device. The storage medium may be a non-transitory storage medium.

The computer-readable signal medium may include a data signal propagated in a baseband or as part of a carrier wave, in which computer-readable program code is carried. This propagated data signal may have many forms, including but not limited to an electromagnetic signal, an optical signal or any suitable combination of the above. The computer-readable signal medium may further be any computer-readable medium other than the computer-readable storage medium, and the computer-readable medium may send, propagate or transmit a program used by or in combination with the instruction execution system, apparatus or device.

A program code encompassed in the computer-readable medium may be transmitted by any suitable medium, including but not limited to, a wireless, wire, optical cable, radio frequency (RF) medium, etc., or any suitable combination of the above.

Computer program codes for executing the operations of the present invention may be written in at least one programming languages or their combinations, and the programming languages include object-oriented programming languages such as Java, Smalltalk. C++, and further include conventional procedural programming languages such as "C" or similar programming languages. The program codes may be completely executed on a computer of a user, partially executed on the computer of the user, executed as an independent software package, partially executed on the computer of the user and partially executed on a remote computer, or completely executed on the remote computer or a server. In the case of involving a remote computer, the remote computer may be connected to the computer of the user through any kind of network, including a local area network (LAN) or a wide area network (WAN), or may be connected to an external computer (for example, through the Internet provided by an Internet service provider).

Claims

1.　A balance monitoring control system for power battery, comprising: an input module, a balance monitoring control module and an execution module, wherein the balance monitoring control module is respectively connected with the input module and the execution module;

the input module is configured to input a voltage of a sampling point of a balance loop, a temperature of a battery module, a current of the power battery and a voltage of a single cell into the balance monitoring control module;
the balance monitoring control module comprises a battery pack balance pre-determination unit, a single cell capacity difference balance control unit, a single cell voltage difference redundancy control unit, a balance loop diagnosing and monitoring unit and a balance watchdog monitoring unit;
the battery pack balance pre-determination unit is configured to pre-determine whether a battery pack is balanced based on the voltage of the single cell and a voltage of the battery module, wherein the voltage of the battery module is obtained based on the voltage of the single cell;
**characterized in that**
the cell capacity difference balance control unit is configured to obtain a capacity of the single cell and a minimum capacity of the single cell based on the temperature of the battery module, the current of the power battery and the voltage of the single cell, determine whether a balance switch corresponding to the single cell is turned on based on a difference between the capacity of the single cell and the minimum capacity of the single cell, generate a first balance control instruction in response to the balance switch corresponding to the single cell being turned on, and send the first balance control instruction to the execution module;

the single cell voltage difference redundancy control unit is configured to monitor the voltage of the single cell in real time after the balance switch is turned on to obtain a monitoring result, determine whether to turn off the balance switch based on the monitoring result, generate a second balance control instruction in response to the balance switch being turned off, and send the second balance control instruction to the execution module;

the balance loop diagnosing and monitoring unit is configured to determine whether to turn off the balance switch based on the voltage of the sampling point of the balance loop after the balance switch is turned on, generate a third balance control instruction in response to the balance switch being turned off, and send the third balance control instruction to the execution module;

the balance watchdog monitoring unit is configured to monitor program running of the system to obtain a program running monitoring result, determine whether to turn off the balance switch based on the program running monitoring result, generate a fourth balance control instruction in response to the balance switch being turned off, and send the fourth balance control instruction to the execution module;

the execution module, configured to control the balance switch based on one of the first balance control instruction, the second balance control instruction, the third balance control instruction and the fourth balance control instruction.

2. The system as claimed in claim 1, wherein the battery pack balance pre-determination unit comprises a voltage computation subunit and a decision-making subunit;

the voltage computation subunit is configured to calculate an average voltage of the single cell and the voltage of the battery module based on the voltage of the single cell and through a formula as follows:

$$Usavg = \sum_{0}^{m} Uis/m \, , Uimod = \sum_{0}^{n} Uis$$

wherein *Uis* represents the voltage of the single cell, m represents the number of single cells in the power battery, *n* represents the number of single cells in the battery module, *Usavg* represents the average voltage of the single cell, and *Uimod* represents the voltage of the battery module, and an average voltage of the battery module is calculated based on the voltage of the battery module and through a formula as follows:

$$Umavg = Uimod/Nmod$$

wherein *Umavg* represents the average voltage of the battery module, and *Nmod* represents the number of modules in the battery pack;

the decision-making subunit is configured to sequentially determine whether a difference between a voltage of each battery module and the average voltage of the battery module and a first preset threshold satisfy a formula: | *Uimod - Umavg*| > *ΔUm,* wherein ΔUm represents the first preset threshold, and the decision-making subunit determines the battery module as an abnormal battery module in response to the formula being satisfied;

the decision-making subunit is further configured to sequentially determine whether a difference between a voltage of each single cell and the average voltage of the single cell and a second preset threshold satisfy a formula as follows:

$$|Uis - Usavg| > \Delta Us$$

the decision-making subunit is configured to determine the single cell as an abnormal single cell in response to the formula being satisfied, wherein Δ*Us* represents the second preset threshold.

3. The system as claimed in claim 1, wherein the cell capacity difference balance control unit comprises a cell capacity computation subunit and a first balance switch control subunit, the cell capacity computation subunit is configured to obtain stabilization duration in response to the voltage of the single cell keeping a stable voltage through interpolation in a two-dimensional timetable based on the temperature of the battery module and the current of the power battery, and the two-dimensional timetable is a two-dimensional table of a temperature, a current of the power battery and stabilization duration obtained based on a battery pack bench test;

the cell capacity computation subunit is further configured to calculate a current duration in response to the current of the power battery being lower than a preset current;

the cell capacity computation subunit is further configured to obtain a state of charge, SOC, of the single cell through an open-circuit voltage method after determining the current duration or a vehicle sleep time period is longer than the stabilization duration, and calculate the capacity of the single cell based on the SOC of the single cell and through a formula as follows:

$$Ahis = SOC * C$$

wherein $C$ represents a nominal capacity, and $Ahis$ represents the capacity of the single cell;

the cell capacity computation subunit is further configured to determine the minimum capacity of the single cell through a formula: $Ahsmin = min(Ahis)$, wherein $Ahsmin$ represents the minimum capacity of the single cell;

the first balance switch control subunit is configured to sequentially obtain a difference between a capacity of each single cell and the minimum capacity of the single cell, and turn on a balance switch of the single cell satisfying a formula as follows:

$$Ahis - Ahsmin > \Delta Ahs$$

wherein $\Delta Ahs$ represents a set threshold of a difference in the capacity of the single cell.

4. The system as claimed in claim 1, wherein the cell voltage difference redundancy control unit comprises a monitoring subunit and a second balance switch control subunit;

the monitoring subunit is configured to monitor the voltage of the single cell in real time to calculate a maximum voltage of the single cell and a minimum voltage of the single cell after the balance switch is turned on;

the second balance switch control subunit is configured to determine to turn off balance switches of all single cells in response to a difference between the maximum voltage of the single cell and the minimum voltage of the single cell and the set threshold satisfy a formula: $|Uismax - Uismin| \leq \Delta U$, wherein $Uismax$ represents the maximum voltage of the single cell, $Uismin$ represents the minimum voltage of the single cell, and $\Delta U$ represents the set threshold.

5. The system as claimed in claim 1, wherein the balance loop diagnosing and monitoring unit comprises a first diagnosing subunit, a second diagnosing subunit and a third balance switch control subunit;

the first diagnosing subunit is configured to diagnose whether an open-circuit fault of the balance loop exists after the balance switch is turned on;

the second diagnosing subunit is configured to diagnose whether a short-circuit fault of the balance loop exists after the balance switch is turned off;

the third balance switch control subunit is configured to turn off all balance switches in response to determining the open-circuit fault exists, and maintain the balance loop in response to determining a short-circuit fault or the open-circuit fault exists.

6. The system as claimed in claim 1, wherein the balance watchdog monitoring unit comprises a program monitoring subunit and a fourth balance switch control subunit;

the program monitoring subunit is configured to monitor system program running and data transmission of the balance monitoring control module in real time;

the fourth balance switch control subunit is configured to continuously add one to a watchdog in response to the program running being monitored to be normal, and turn off all balance switches in response to the program running being monitored to be abnormal and duration after the balance switches are turned on being monitored to reach a preset time value.

7. The system as claimed in claim 1, wherein the execution module is configured to send one of the first balance control instruction, the second balance control instruction, the third balance control instruction and the fourth balance control instruction to a balance switch register, so that the balance switch register to turns on or turns off the balance switch based on the one of the first balance control instruction, the second balance control instruction, the third balance control instruction and the fourth balance control instruction.

8. A method for balance monitoring control of a power battery, executed by a monitoring mechanism of a three-layer software architecture in a balance monitoring control module, comprising:

obtaining a voltage of a single cell, a temperature of a battery module, a current of the power battery and a voltage of a sampling point of a balance loop;

pre-determining whether a battery pack is balanced based on the voltage of the single cell and a voltage of the battery module, wherein the voltage of the battery module is obtained based on the voltage of the single cell;

further **characterized by**

obtaining a capacity of the single cell and a minimum capacity of the single cell based on the temperature of the battery module, the current of the power battery and the voltage of the single cell, determining whether a balance switch corresponding to the single cell is turned on based on difference between the capacity of the single cell and the minimum capacity of the single cell, generating a first balance control instruction in response to the balance switch corresponding to the single cell being turned on, and sending the first balance control instruction to an execution module;

monitoring the voltage of the single cell in real time after the balance switch is turned on to obtain a monitoring result, determining whether to turn off the balance switch based on the monitoring result, generating a second balance control instruction in response to the balance switch being turned off, and sending the second balance control instruction to the execution module;

determining whether to turn off the balance switch based on the voltage of the sampling point of the balance loop after the balance switch is turned on, generating a third balance control instruction in response to the balance switch being turned off, and sending the third balance control instruction to the execution module;

monitoring a program running of a system to obtain a monitoring result, determining whether to turn off the balance switch based on the monitoring result, generating a fourth balance control instruction in response to the balance switch being turned off, and sending the fourth balance control instruction to the execution module.

9. A server, comprising:

at least one processor;

a storage apparatus, configured to store at least one program;

wherein the at least one program is configured to control the at least one processor to execute the method for balance monitoring control of a power battery as claimed in claim 8 when executing by the at least one processor.

10. A computer-readable storage medium, storing a computer program, wherein the computer program implements the method for balance monitoring control of a power battery as claimed in claim 8 when executing by the at least one processor.

**Patentansprüche**

1. Balanceüberwachungssteuerungssystem für eine Leistungsbatterie, umfassend: ein Eingangsmodul, ein Balanceüberwachungsteuerungsmodul und ein Ausführungsmodul, wobei das Balanceüberwachungsteuerungsmodul jeweils mit dem Eingangsmodul und dem Ausführungsmodul verbunden ist;

das Eingangsmodul konfiguriert ist, um eine Spannung eines Abtastpunkts einer Balanceschleife, eine Temperatur eines Batteriemoduls, einen Strom der Leistungsbatterie und eine Spannung einer Einzelzelle in das Balanceüberwachungssteuerungsmodul einzugeben;

das Balanceüberwachungssteuerungsmodul eine Batteriepack-Balancevorbestimmungseinheit, eine Einzelzellenkapazitätsdifferenzbalancesteuerungseinheit, eine Einzelzellenspannungsdifferenzredundanzsteuerungseinheit, eine Balanceschleifendiagnose- und -überwachungseinheit und eine Balance-Watchdog-Überwachungseinheit umfasst;

die Batteriepack-Balancevorbestimmungseinheit konfiguriert ist, um basierend auf der Spannung der Einzelzelle und einer Spannung des Batteriemoduls vorzubestimmen, ob ein Batteriepack balanciert ist, wobei die Spannung des Batteriemoduls basierend auf der Spannung der Einzelzelle ermittelt wird;

**dadurch gekennzeichnet, dass**

die Zellkapazitätsdifferenzbalancessteuerungseinheit konfiguriert ist, um eine Kapazität der Einzelzelle und eine Mindestkapazität der Einzelzelle basierend auf der Temperatur des Batteriemoduls, dem Strom der Leistungsbatterie und der Spannung der Einzelzelle zu ermitteln, basierend auf einer Differenz zwischen der Kapazität der Einzelzelle und der Mindestkapazität der Einzelzelle zu bestimmen, ob ein der Einzelzelle entsprechender Balanceschalter eingeschaltet ist, als Reaktion darauf, dass der der Einzelzelle entsprechende Balanceschalter eingeschaltet ist, eine erste Balancesteuerungsanweisung zu erzeugen und die erste Balancesteuerungsanweisung an das Ausführungsmodul zu senden;

die Einzelzellenspannungsdifferenzredundanzsteuereinheit konfiguriert ist, um die Spannung der Einzelzelle in Echtzeit zu überwachen, nachdem der Balanceschalter eingeschaltet wurde, um ein Überwachungsergebnis zu ermitteln, basierend auf dem Überwachungsergebnis zu bestimmen, ob der Balanceschalter ausgeschaltet werden soll, als Reaktion auf das Ausschalten des Balanceschalters eine zweite Balancesteuerungsanweisung zu erzeugen und die zweite Balancesteuerungsanweisung an das Ausführungsmodul zu senden;

die Balancesschleifendiagnose- und überwachungseinheit konfiguriert ist, um basierend auf der Spannung des Abtastpunkts der Balanceschleife nach dem Einschalten des Balanceschalters zu bestimmen, ob der Balanceschalter ausgeschaltet werden soll, als Reaktion auf das Ausschalten des Balanceschalters eine dritte Balancesteuerungsanweisung zu erzeugen und die dritte Balancesteuerungsanweisung an das Ausführungsmodul zu senden;

die Balance-Watchdog-Überwachungseinheit konfiguriert ist, um den Programmablauf des Systems zu überwachen, um ein Programmablaufüberwachungsergebnis zu ermitteln, basierend auf dem Programmablaufüberwachungsergebnis zu bestimmen, ob der Balanceschalter ausgeschaltet werden soll, als Reaktion auf das Ausschalten des Balanceschalters eine vierte Balancesteuerungsanweisung zu erzeugen und die vierte Balancesteuerungsanweisung an das Ausführungsmodul zu senden;

das Ausführungsmodul konfiguriert ist, um den Balanceschalter basierend auf einer von der ersten Balancesteuerungsanweisung, der zweiten Balancesteuerungsanweisung, der dritten Balancesteuerungsanweisung und der vierten Balancesteuerungsanweisung zu steuern.

2. System nach Anspruch 1, wobei die Batteriepack-Balancevorbestimmungseinheit eine Spannungsberechnungsuntereinheit und eine Entscheidungsfindungsuntereinheit umfasst;

die Spannungsberechnungsuntereinheit konfiguriert ist, um eine durchschnittliche Spannung der Einzelzelle und die Spannung des Batteriemoduls basierend auf der Spannung der Einzelzelle und anhand der folgenden Formel zu berechnen:

$$Usavg = \sum_{0}^{m} Uis/m \, , Uimod = \sum_{0}^{n} Uis$$

wobei *Uis* die Spannung der Einzelzelle darstellt, m die Anzahl der Einzelzellen in der Leistungsbatterie darstellt, *n* die Anzahl der Einzelzellen in dem Batteriemodul darstellt, *Usavg* die durchschnittliche Spannung der Einzelzelle darstellt und *Uimod* die Spannung des Batteriemoduls darstellt, und eine durchschnittliche Spannung des Batteriemoduls basierend auf der Spannung des Batteriemoduls und anhand der folgenden Formel berechnet wird:

$$Umavg = Uimod/Nmod$$

wobei *Umavg* die durchschnittliche Spannung des Batteriemoduls darstellt und *Nmod* die Anzahl der Module im Batteriepack darstellt;

die Entscheidungsuntereinheit konfiguriert ist, um sequenziell zu bestimmen, ob eine Differenz zwischen einer Spannung jedes Batteriemoduls und der durchschnittlichen Spannung des Batteriemoduls und einem ersten voreingestellter Schwellenwert die folgende Formel erfüllt: $|Uimod - Umavg| > \Delta Um,$ wobei $\Delta Um$ den ersten voreingestellten Schwellenwert darstellt und die Entscheidungsuntereinheit als Reaktion darauf, dass die Formel erfüllt ist, das Batteriemodul als ein abnormales Batteriemodul bestimmt;

die Entscheidungsuntereinheit ferner konfiguriert ist, um sequenziell zu bestimmen, ob eine Differenz zwischen einer Spannung jeder Einzelzelle und der durchschnittlichen Spannung der Einzelzelle und einem zweiten voreingestellten Schwellenwert die folgende Formel erfüllt:

$$|Uis - Usavg| > \Delta Us$$

die Entscheidungsuntereinheit konfiguriert ist, um die Einzelzelle als Reaktion darauf, das die Formel erfüllt ist, als eine abnormale Einzelzelle zu bestimmen, wobei $\Delta Us$ den zweiten voreingestellten Schwellenwert darstellt.

3. System nach Anspruch 1, wobei die Zellkapazitätsdifferenzbalancessteuerungseinheit eine Zellkapazitätsberechnungsuntereinheit und eine erste Balanceschaltersteuerungsuntereinheit umfasst, wobei die Zellkapazitätsberechnungsuntereinheit konfiguriert ist, um als Reaktion darauf, dass die Spannung der Einzelzelle durch Interpolation in einer zweidimensionalen Zeittabelle basierend auf der Temperatur des Batteriemoduls und dem Strom der Leistungsbatterie eine stabile Spannung beibehält, eine Stabilisierungsdauer zu ermitteln, und die zweidimensionale Zeittabelle eine zweidimensionale Tabelle einer Temperatur, eines Stroms der Leistungsbatterie und einer basierend auf einem Prüfstandstests des Batteriepacks ermittelten Stabilisierungsdauer ist;

die Zellkapazitätsberechnungsuntereinheit ferner konfiguriert ist, um in Reaktion darauf, dass der Strom der Leistungsbatterie niedriger ist als ein voreingestellter Strom, eine Stromdauer zu berechnen;
die Zellkapazitätsberechnungsuntereinheit ferner konfiguriert ist, um einen Ladezustand, SOC, der Einzelzelle durch ein Leerlaufspannungsverfahren zu ermitteln, nachdem bestimmt wurde, dass die Stromdauer oder eine Fahrzeugruhezeitdauer länger ist als die Stabilisierungsdauer, und um die Kapazität der Einzelzelle basierend auf dem SOC der Einzelzelle und anhand der folgenden Formel zu berechnen:

$$Ahis = SOC * C$$

wobei C eine Nennkapazität darstellt und *Ahis* die Kapazität der Einzelzelle darstellt;
die Zellkapazitätsberechnungsuntereinheit ferner konfiguriert ist, um die Mindestkapazität der Einzelzelle anhand der folgenden Formel zu bestimmen: *Ahsmin = min*(*Ahis*), wobei *Ahsmin* die Mindestkapazität der Einzelzelle darstellt;
die erste Balanceschaltersteuerungsuntereinheit konfiguriert ist, um sequenziell eine Differenz zwischen einer Kapazität jeder Einzelzelle und der Mindestkapazität der Einzelzelle zu ermitteln und einen Balanceschalter der Einzelzelle einzuschalten, die die folgende Formel erfüllt:

$$Ahis - Ahsmin > \Delta Ahs$$

wobei Δ*Ahs* einen festgelegten Schwellenwert einer Differenz in der Kapazität der Einzelzelle darstellt.

4. System nach Anspruch 1, wobei die Zellspannungsdifferenzredundanzsteuerungseinheit eine Überwachungsuntereinheit und eine zweite Balanceschaltersteuerungsuntereinheit umfasst;

die Überwachungsuntereinheit konfiguriert ist, um die Spannung der Einzelzelle in Echtzeit zu überwachen, um nach dem Einschalten des Balanceschalters eine maximale Spannung der Einzelzelle und eine minimale Spannung der Einzelzelle zu berechnen;
die zweite Balanceschaltersteuerungsuntereinheit konfiguriert ist, um zu bestimmen, die Balanceschalter aller Einzelzellen als Reaktion darauf abzuschalten, dass eine Differenz zwischen der maximalen Spannung der Einzelzelle und der minimalen Spannung der Einzelzelle und dem festgelegten Schwellenwert die folgende Formel erfüllt: |*Uismax - Uismin*| ≤ Δ*U*, wobei *Uismax* die maximale Spannung der Einzelzelle darstellt, *Uismin* die minimale Spannung der Einzelzelle darstellt und Δ*U* den festgelegten Schwellenwert darstellt.

5. System nach Anspruch 1, wobei die Balanceschleifendiagnose- und überwachungseinheit eine erste Diagnoseuntereinheit, eine zweite Diagnoseuntereinheit und eine dritte Balanceschaltersteuerungsuntereinheit umfasst;

die erste Diagnoseuntereinheit konfiguriert ist, um zu diagnostizieren, ob nach dem Einschalten des Balanceschalters ein Leerlauffehler der Balanceschleife vorliegt;
die zweite Diagnoseuntereinheit konfiguriert ist, um zu diagnostizieren, ob nach dem Ausschalten des Balanceschalters ein Kurzschlussfehler der Balanceschleife vorliegt;
die dritte Balanceschaltersteuerungsuntereinheit konfiguriert ist, um alle Balanceschalter als Reaktion auf die Bestimmung, dass der Leerlauffehler vorliegt, auszuschalten und die Balanceschleife als Reaktion auf die Bestimmung, dass ein Kurzschlussfehler oder der Leerlauffehler vorliegt, aufrechtzuerhalten.

6. System nach Anspruch 1, wobei die Balance-Watchdog-Überwachungseinheit eine Programmüberwachungsuntereinheit und eine vierte Balanceschaltersteuerungsuntereinheit umfasst;

die Programmüberwachungsuntereinheit konfiguriert ist, um die Systemprogrammausführung und die Datenübertragung des Balanceüberwachungssteuerungsmoduls in Echtzeit zu überwachen;

die vierte Balanceschaltersteuerungsuntereinheit konfiguriert ist, um als Reaktion auf einen als normal überwachten Programmablauf kontinuierlich eins zu einem Watchdog zu addieren, und um als Reaktion auf einen als abnormal überwachten Programmablauf alle Balanceschalter auszuschalten und die Dauer nach dem Einschalten der Balanceschalter zu überwachen, um einen voreingestellten Zeitwert zu erreichen.

**7.** System nach Anspruch 1, wobei das Ausführungsmodul konfiguriert ist, um eine von der ersten Balancesteuerungsanweisung, der zweiten Balancesteuerungsanweisung, der dritten Balancesteuerungsanweisung und der vierten Balancesteuerungsanweisung an ein Balanceschalterregister zu senden, damit das Balanceschalterregister den Balanceschalter basierend auf der einen von der ersten Balancesteuerungsanweisung, der zweiten Balancesteuerungsanweisung, der dritten Balancesteuerungsanweisung und der vierten Balancesteuerungsanweisung einschaltet oder ausschaltet.

**8.** Verfahren zur Balanceüberwachungssteuerung einer Leistungsbatterie, das durch einen Überwachungsmechanismus einer dreischichtigen Softwarearchitektur in einem Balanceüberwachungssteuerungsmodul ausgeführt wird, umfassend:

das Ermitteln einer Spannung einer Einzelzelle, einer Temperatur eines Batteriemoduls, eines Stroms der Leistungsbatterie und einer Spannung eines Abtastpunkts einer Balanceschleife;
das Vorbestimmen, ob ein Batteriepack balanciert ist, und zwar basierend auf der Spannung der Einzelzelle und einer Spannung des Batteriemoduls, wobei die Spannung des Batteriemoduls basierend auf der Spannung der Einzelzelle ermittelt wird;
ferner **gekennzeichnet durch**
das Ermitteln einer Kapazität der Einzelzelle und einer Mindestkapazität der Einzelzelle basierend auf der Temperatur des Batteriemoduls, dem Strom der Leistungsbatterie und der Spannung der Einzelzelle, das Bestimmen, ob ein der Einzelzelle entsprechender Balanceschalter eingeschaltet ist, basierend auf einer Differenz zwischen der Kapazität der Einzelzelle und der Mindestkapazität der Einzelzelle, das Erzeugen einer ersten Balancesteuerungsanweisung als Reaktion darauf, dass der der Einzelzelle entsprechende Balanceschalter eingeschaltet ist, und das Senden der ersten Balancesteuerungsanweisung an ein Ausführungsmodul;
das Überwachen der Spannung der Einzelzelle in Echtzeit nach dem Einschalten des Balanceschalters, um ein Überwachungsergebnis zu ermitteln, das Bestimmen, ob der Balanceschalter ausgeschaltet werden soll, basierend auf dem Überwachungsergebnis, das Erzeugen einer zweiten Balancesteuerungsanweisung als Reaktion auf das Ausschalten des Balanceschalters und das Senden der zweiten Balancesteuerungsanweisung an das Ausführungsmodul;
das Bestimmen, ob der Balanceschalter ausgeschaltet werden soll, basierend auf der Spannung des Abtastpunkts der Balanceschleife, nachdem der Balanceschalter eingeschaltet wurde, das Erzeugen einer dritten Balancesteuerungsanweisung als Reaktion auf das Ausschalten des Balanceschalters und das Senden der dritten Balancesteuerungsanweisung an das Ausführungsmodul;
das Überwachen eines Programmablaufs eines Systems, um ein Überwachungsergebnis zu ermitteln, das Bestimmen, ob der Balanceschalter ausgeschaltet werden soll, basierend auf dem Überwachungsergebnis, das Erzeugen einer vierten Balancesteuerungsanweisung als Reaktion auf das Ausschalten des Balanceschalters und das Senden der vierten Balancesteuerungsanweisung an das Ausführungsmodul.

**9.** Server, umfassend:

mindestens einen Prozessor;
eine Speicherungsvorrichtung, die konfiguriert ist, um mindestens ein Programm zu speichern;
wobei das mindestens eine Programm konfiguriert ist, um den mindestens einen Prozessor zu steuern, um das Verfahren zur Balanceüberwachungssteuerung einer Leistungsbatterie nach Anspruch 8 auszuführen, wenn es von dem mindestens einen Prozessor ausgeführt wird.

**10.** Computerlesbares Speicherungsmedium, das ein Computerprogramm speichert, wobei das Computerprogramm das Verfahren zur Balanceüberwachungssteuerung einer Leistungsbatterie nach Anspruch 8 implementiert, wenn es von dem mindestens einen Prozessor ausgeführt wird.

**Revendications**

**1.** Système de commande de surveillance d'équilibre pour batterie d'alimentation, comprenant : un module d'entrée, un module de commande de surveillance d'équilibre et un module d'exécution, dans lequel le module de commande de surveillance d'équilibre est respectivement connecté au module d'entrée et au module d'exécution ;

le module d'entrée est configuré pour entrer une tension d'un point d'échantillonnage d'une boucle d'équilibre, une température d'un module de batterie, un courant de la batterie d'alimentation et une tension d'une cellule unique dans le module de commande de surveillance d'équilibre ;

le module de commande de surveillance d'équilibrage comprend une unité de prédétermination d'équilibrage de bloc-batterie, une unité de commande d'équilibrage de différence de capacité à cellule unique, une unité de commande de redondance de différence de tension à cellule unique, une unité de diagnostic et de surveillance de boucle d'équilibre et une unité de surveillance de chien de garde d'équilibre ;

l'unité de prédétermination d'équilibrage de bloc-batterie est configurée pour pré-déterminer si un bloc-batterie est équilibré sur la base de la tension de la cellule unique et d'une tension du module de batterie, dans lequel la tension du module de batterie est obtenue sur la base de la tension de la cellule unique ;

**caractérisé en ce que**

l'unité de commande d'équilibrage de différence de capacité de cellule est configurée pour obtenir une capacité de la cellule unique et une capacité minimale de la cellule unique sur la base de la température du module de batterie, du courant de la batterie d'alimentation et de la tension de la cellule unique, déterminer si un commutateur d'équilibrage correspondant à la cellule unique est activé sur la base d'une différence entre la capacité de la cellule unique et la capacité minimale de la cellule unique cellule, générer une première instruction de commande d'équilibre en réponse à l'allumage du commutateur de balance correspondant à la cellule unique, et envoyer la première instruction de commande d'équilibre au module d'exécution ;

l'unité de commande de redondance de différence de tension de cellule unique est configurée pour surveiller la tension de la cellule unique en temps réel après l'allumage du commutateur d'équilibrage afin d'obtenir un résultat de surveillance, déterminer s'il faut éteindre le commutateur d'équilibrage sur la base du résultat de surveillance, générer une deuxième instruction de commande d'équilibrage en réponse à l'arrêt du commutateur d'équilibre, et envoyer la deuxième instruction de commande d'équilibre au module d'exécution ;

l'unité de diagnostic et de surveillance de boucle d'équilibre est configurée pour déterminer s'il faut éteindre le commutateur d'équilibre sur la base de la tension du point d'échantillonnage de la boucle d'équilibre après l'allumage du commutateur d'équilibre, générer une troisième instruction de commande d'équilibre en réponse à l'arrêt du commutateur d'équilibre, et envoyer la troisième instruction de commande d'équilibre au module d'exécution ;

l'unité de surveillance de chien de garde de balance est configurée pour surveiller le fonctionnement de programme du système afin d'obtenir un résultat de surveillance de fonctionnement de programme, déterminer s'il faut éteindre le commutateur de balance sur la base du résultat de surveillance de déroulement de programme, générer une quatrième instruction de commande de balance en réponse à la désactivation du commutateur de balance, et envoyer la quatrième instruction de commande de balance au module d'exécution ;

le module d'exécution, configuré pour commander le commutateur de balance sur la base de l'une parmi la première instruction de commande de balance, la deuxième instruction de commande de balance, la troisième instruction de commande de balance et la quatrième instruction de commande de balance.

2. Système selon la revendication 1, dans lequel l'unité de prédétermination d'équilibrage de bloc-batterie comprend une sous-unité de calcul de tension et une sous-unité de prise de décision ;

la sous-unité de calcul de tension est configurée pour calculer une tension moyenne de la cellule unique et la tension du module de batterie sur la base de la tension de la cellule unique et à l'aide d'une formule comme suit :

$$Usavg = \sum_0^m Uis/m, Uimod = \sum_0^n Uis$$

dans lequel *Uis* représente la tension de la cellule unique, m représente le nombre de cellules uniques dans la batterie d'alimentation, n représente le nombre de cellules uniques dans le module de batterie, *Usavg* représente la tension moyenne de la cellule unique, et *Uimod* représente la tension du module de batterie, et une tension moyenne du module de batterie est calculé sur la base de la tension du module de batterie et selon une formule comme suit :

$$Umavg = Uimod/Nmod$$

dans lequel *Umavg* représente la tension moyenne du module de batterie, et *Nmod* représente le nombre de modules dans le bloc-batterie ;

la sous-unité de prise de décision est configurée pour déterminer séquentiellement si une différence entre une tension de chaque module de batterie et la tension moyenne du module de batterie et un premier seuil prédéfini satisfont une formule : $|Uimod \text{-} Umavg|i > \Delta Um,$ dans lequel $\Delta Um$ représente le premier seuil prédéfini, et la sous-unité de prise de décision détermine la module de batterie comme un module de batterie anormal en réponse à la satisfaction de la formule ;

la sous-unité de prise de décision est en outre configurée pour déterminer séquentiellement si une différence entre une tension de chaque cellule unique et la tension moyenne de la cellule unique et un second seuil prédéfini satisfont une formule comme suit :

$$|Uis \text{—} Usavg| > \Delta Us$$

la sous-unité de prise de décision est configurée pour déterminer la cellule unique en tant que cellule unique anormale en réponse à la formule étant satisfaite, dans lequel $\Delta Us$ représente le second seuil prédéfini.

3. Système selon la revendication 1, dans lequel l'unité de commande d'équilibrage de différence de capacité de cellule comprend une sous-unité de calcul de capacité de cellule et une première sous-unité de commande de commutation d'équilibre, la sous-unité de calcul de capacité de cellule est configurée pour obtenir une durée de stabilisation en réponse à la tension de la cellule unique maintenant une tension stable par interpolation dans un horaire bidimensionnel basé sur la température de la le module de batterie et le courant de la batterie d'alimentation, et l'horaire bidimensionnel est un tableau bidimensionnel d'une température, d'un courant de la batterie d'alimentation et d'une durée de stabilisation obtenue sur la base d'un test au banc de bloc-batterie ;

la sous-unité de calcul de capacité de cellule est en outre configurée pour calculer une durée de courant en réponse au fait que le courant de la batterie d'alimentation est inférieur à un courant prédéfini ;

la sous-unité de calcul de capacité de cellule est en outre configurée pour obtenir un état de charge, SOC, de la cellule unique par un procédé de tension en circuit ouvert après détermination de la durée actuelle ou d'une période de sommeil de véhicule est supérieure à la durée de stabilisation, et pour calculer la capacité de la cellule unique sur la base du SOC de la cellule unique et par une formule comme suit :

$$Ahis = SOC * C$$

dans lequel C représente une capacité nominale, et *Ahis* représente la capacité de la cellule unique ;

la sous-unité de calcul de capacité de cellule est en outre configurée pour déterminer la capacité minimale de la cellule unique au moyen d'une formule : *Ahsmin = min*(*Ahis*), *dans lequel Ahsmin* représente la capacité minimale de la cellule unique ;

la première sous-unité de commande de commutation d'équilibrage est configurée pour obtenir séquentiellement une différence entre une capacité de chaque cellule unique et la capacité minimale de la cellule unique, et pour activer un commutateur d'équilibrage de la cellule unique satisfaisant une formule comme suit :

$$Ahis \text{-} Ahsmin > \Delta Ahs$$

dans lequel $\Delta Ahs$ représente un seuil fixé d'une différence dans la capacité de la cellule unique.

4. Système selon la revendication 1, dans lequel l'unité de commande de redondance de différence de tension de cellule comprend une sous-unité de surveillance et une deuxième sous-unité de commande de commutateur d'équilibrage ;

la sous-unité de surveillance est configurée pour surveiller la tension de la cellule unique en temps réel afin de calculer une tension maximale de la cellule unique et une tension minimale de la cellule unique après l'allumage du commutateur d'équilibrage ;

la deuxième sous-unité de commande de commutation d'équilibrage est configurée pour déterminer de désactiver les commutateurs d'équilibrage de toutes les cellules individuelles en réponse à une différence entre la tension maximale de la cellule unique et la tension minimale de la cellule unique et le seuil fixé satisfont une formule : $|Uismax \text{-} Uismin| \leq \Delta U,$ dans lequel *Uismax* représente la tension maximale de la cellule unique, *Uismin* représente la tension minimale de la cellule unique, et $\Delta U$ représente le seuil réglé.

**5.** Système selon la revendication 1, dans lequel l'unité de diagnostic et de surveillance de boucle d'équilibrage comprend une première sous-unité de diagnostic, une deuxième sous-unité de diagnostic et une troisième sous-unité de commande de commutateur d'équilibrage ;

la première sous-unité de diagnostic est configurée pour diagnostiquer si un défaut en circuit ouvert de la boucle d'équilibrage existe après l'allumage du commutateur d'équilibrage ;
la deuxième sous-unité de diagnostic est configurée pour diagnostiquer si un défaut de court-circuit de la boucle d'équilibrage existe après la désactivation du commutateur d'équilibrage ;
la troisième sous-unité de commande de commutateur d'équilibrage est configurée pour éteindre tous les commutateurs d'équilibrage en réponse à la détermination de l'existence d'un défaut en circuit ouvert, et maintenir la boucle d'équilibrage en réponse à la détermination d'un défaut de court-circuit ou de l'existence du défaut en circuit ouvert.

**6.** Système selon la revendication 1, dans lequel l'unité de surveillance de chien de garde de balance comprend une sous-unité de surveillance de programme et une quatrième sous-unité de commande de commutateur de balance ;

la sous-unité de surveillance de programme est configurée pour surveiller en temps réel l'exécution de programme de système et la transmission de données du module de commande de surveillance d'équilibre ;
la quatrième sous-unité de commande de commutation d'équilibrage est configurée pour en ajouter continuellement un à un chien de garde en réponse au fait que l'exécution du programme est surveillée pour être normale, et désactiver tous les commutateurs d'équilibrage en réponse à l'exécution du programme étant surveillée comme étant anormale et la durée après l'allumage des commutateurs d'équilibrage étant surveillée pour atteindre une valeur de temps prédéfinie.

**7.** Système selon la revendication 1, dans lequel le module d'exécution est configuré pour envoyer l'une parmi la première instruction de commande de balance, la deuxième instruction de commande de balance, la troisième instruction de commande de balance et la quatrième instruction de commande de balance à un registre de commutateur de balance, de sorte que le registre de commutateur de balance active ou désactive le commutateur de balance sur la base de l'une des premières instructions de commande de balance, la deuxième instruction de commande d'équilibre, la troisième instruction de commande d'équilibre et la quatrième instruction de commande d'équilibre.

**8.** Procédé de commande de surveillance d'équilibrage d'une batterie d'alimentation, exécuté par un mécanisme de surveillance d'une architecture logicielle à trois couches dans un module de commande de surveillance d'équilibre, comprenant :

l'obtention d'une tension d'une cellule unique, d'une température d'un module de batterie, d'un courant de la batterie d'alimentation et d'une tension d'un point d'échantillonnage d'une boucle d'équilibrage ;
la pré-détermination du fait de savoir si un bloc-batterie est équilibré sur la base de la tension de la cellule unique et d'une tension du module de batterie, dans lequel la tension du module de batterie est obtenue sur la base de la tension de la cellule unique ;
en outre **caractérisé par**
l'obtention d'une capacité de la cellule unique et d'une capacité minimale de la cellule unique sur la base de la température du module de batterie, du courant de la batterie d'alimentation et de la tension de la cellule unique, la détermination de savoir si un commutateur d'équilibrage correspondant à la cellule unique est activé sur la base de la différence entre la capacité de la cellule unique et la capacité minimale de la cellule unique, la génération d'une première instruction de commande de balance en réponse à l'allumage du commutateur de balance correspondant à la cellule unique, et l'envoi de la première instruction de commande de balance à un module d'exécution ;
la surveillance de la tension de la cellule unique en temps réel après l'allumage du commutateur d'équilibrage pour obtenir un résultat de surveillance, le fait de déterminer s'il faut éteindre le commutateur d'équilibrage sur la base du résultat de surveillance, la génération d'une deuxième instruction de commande d'équilibrage en réponse à l'arrêt du commutateur d'équilibre, et l'envoi de la deuxième instruction de commande d'équilibre au module d'exécution ;
le fait de déterminer s'il faut éteindre le commutateur d'équilibre sur la base de la tension du point d'échantillonnage de la boucle d'équilibre après l'allumage du commutateur d'équilibre, la génération d'une troisième instruction de commande d'équilibre en réponse à l'arrêt du commutateur d'équilibre, et l'envoi de la troisième instruction de commande d'équilibre au module d'exécution ;

la surveillance d'un programme d'exécution d'un système pour obtenir un résultat de surveillance, le fait de déterminer s'il faut éteindre le commutateur de balance sur la base du résultat de surveillance, la génération d'une quatrième instruction de commande de balance en réponse à la désactivation du commutateur de balance, et l'envoi de la quatrième instruction de commande de balance au module d'exécution.

9. Serveur, comprenant :

au moins un processeur ;
un appareil de stockage, configuré pour stocker au moins un programme ;
dans lequel l'au moins un programme est configuré pour commander l'au moins un processeur pour exécuter le procédé de commande de surveillance d'équilibre d'une batterie d'alimentation selon la revendication 8 lorsqu'il est exécuté par l'au moins un processeur.

10. Support de stockage lisible par un ordinateur, stockant un programme informatique, dans lequel le programme informatique met en œuvre le procédé de commande de surveillance d'équilibre d'une batterie d'alimentation selon la revendication 8 lorsqu'il est exécuté par l'au moins un processeur.

110

120

130

**Balance monitoring control module**

121 — Battery pack balance pre-determination unit

Cell capacity difference balance control unit — 122

Cell voltage difference redundancy control unit — 123

124 — Balance loop diagnosing and monitoring unit

Balance watchdog monitoring unit — 125

Input module

Execution module

**Fig. 1**

220

**Balance monitoring control module**

221 — Battery pack balance pre-determination unit

2211 — Voltage computation subunit | Decision-making subunit

210

Cell capacity difference balance control unit

Cell capacity computation subunit — 2221 — 222

First balance switch control subunit — 2222

230

Cell voltage difference redundancy control unit — 223

Monitoring subunit — 2231

2232 — Second balance switch control subunit

Balance loop diagnosing and monitoring unit

2241 — First diagnosing subunit | Second diagnosing subunit — 2242

224 — Third balance switch control subunit — 2243

Balance watchdog monitoring unit

Program monitoring subunit — 2251 — 225

2252 — Fourth balance switch control subunit

Input module

Execution module

**Fig. 2**

Obtain a voltage of a cell, a temperature of a battery module, a current of a tractionpower battery and a voltage of a sampling point of a balance loop

~ S310

Pre-determine whether a battery pack is balanced according to the voltage of the cell and a voltage of the battery module

~ S320

Obtain a capacity of the cell and a minimum capacity of the cell according to the temperature of the battery module, the current of the tractionpower battery and the voltage of the cell, determine whether a balance switch corresponding to the cell is turned on according to a difference between the capacity of the cell and the minimum capacity of the cell, generate a first balance control instruction under the condition that the balance switch corresponding to the cell is turned on, and send the first balance control instruction to an execution module

~ S330

Monitor the voltage of the cell in real time after the balance switch is turned on, determine whether to turn off the balance switch according to a monitoring result, generate a second balance control instruction under the condition that the balance switch is turned off, and send the second balance control instruction to the execution module

~ S340

Determine whether to turn off the balance switch according to the voltage of the sampling point of the balance loop after the balance switch is turned on, generate a third balance control instruction under the condition that the balance switch is turned off, and send the third balance control instruction to the execution module

~ S350

Monitor program running of the system, determine whether to turn off the balance switch according to a monitoring result, generate a fourth balance control instruction under the condition that the balance switch is turned off, and send the fourth balance control instruction to the execution module

~ S360

**Fig. 3**

Application layer

Battery pack balance pre-determination

Single cell capacity difference balance control

Single cell voltage difference redundancy control

Integration layer

Balance loop diagnosing and monitoring

Platform software layer

Balance watchdog monitoring

Fig. 4

**Fig. 5**

Start with a balance starting
determination condition

↓

1. Set different voltage stabilization time *Tmap* according to
different temperatures of a module
2. Compute time *Ti* when a current is lower than a certain
threshold
3. Read vehicle sleep time *T* of an electric vehicle

↓

*T* or *Ti* > *Tmap*   Y →

N ↓

1. Compute *SOCis* of a single cell in a battery pack and a
corresponding capacity *Ahis* of the single cell
2. Compute a minimum capacity *Ahsmin* of the single cell
corresponding to a minimum *SOCsmin* in the battery pack

↓

*Ahis-Ahsmin* > △*Ahs*

N

Y ↓

Next step

Fig. 6

Fig. 7

| Storage apparatus | 82 | | Input apparatus | 83 |
|---|---|---|---|---|

| Processor | 81 | | Output apparatus | 84 |
|---|---|---|---|---|

**Fig. 8**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 106042961 A